# EUROPÄISCHE PATENTSCHRIFT

(11) **EP 1 076 829 B1**
(45) Veröffentlichungstag und Bekanntmachung des Hinweises auf die Patenterteilung: **23.04.2003**
(21) Anmeldenummer: 99932667.1
(22) Anmeldetag: 05.05.1999
(51) Int. Cl.: G01R 19/25

(54) **VERFAHREN UND SCHALTUNGSANORDNUNG ZUR STROMERFASSUNG**
METHOD AND CIRCUIT FOR MEASURING A CURRENT
PROCEDE ET CIRCUIT POUR DETECTER UN COURANT

(30) Priorität: 07.05.1998 DE 19822127
(43) Veröffentlichungstag der Anmeldung: 21.02.2001
(73) Patentinhaber: SIEMENS AKTIENGESELLSCHAFT, 80333 München (DE)
(72) Erfinder: BAUMGÄRTL, Ulrich, D-13599 Berlin (DE); HOCHGRAEF, Holger, D-16845 Ganzer (DE); RÖHL, Wolfgang, D-13503 Berlin (DE)
(86) Internationale Anmeldenummer: DE9901401
(87) Internationale Veröffentlichungsnummer: WO99057568

(56) Entgegenhaltungen:
- PATENT ABSTRACTS OF JAPAN vol. 014, no. 021 (P-990), 17. Januar 1990 (1990-01-17) & JP 01 263563 A (NEC CORP), 20. Oktober 1989 (1989-10-20)

## Beschreibung

Die vorliegende Erfindung betrifft ein Verfahren und eine Schaltungsanordnung zur Stromerfassung nach Betrag und Phasenlage und ist anwendbar beispielsweise zur genauen Auslösung von elektronischen Auslösern in Leistungsschaltern.

Für elektronische Auslöser in Leistungsschaltern wird eine immer genauere Einhaltung vorgegebener Auslösekennlinien und Anzeige von Stromwerten gefordert. Eine bekannte Maßnahme zur Erzielung einer höheren Genauigkeit der Stromerfassung ist der Einsatz von Rogowskispulen mit nachgeschaltetem Integrator und Normierverstärker.

Eine weitere bekannte Maßnahme zur Erhöhung der Genauigkeit ist eine Erhöhung der Abtastrate des analogen Signals sowie eine verbesserte softwaremäßige Auswertung der abgetasteten Werte.

Die Abtastung von Meßgrößen sowie die Weiterverarbeitung der abgetasteten Meßwerte zum Erzeugen eines Auslösesignals in Abhängigkeit von der Größe und der Dauer eines Überstromes ist in der DE 35 22 739 A1 beschrieben. Bei diesem Verfahren werden die abgetasteten Meßwerte in digitale Werte umgeformt, die einer vorgegebenen Funktion entsprechend gewichtet und aufsummiert werden. Bei einem oberhalb eines vorgegebenen Vergleichswertes liegenden Summenwert wird das Auslösesignal gebildet.

Die Erhöhung der Abtastrate ist ein gemäß dem bekannten Stand der Technik übliches Verfahren. Dieses Verfahren erfordert jedoch leistungsfähigere Prozessoren, die relativ teuer sind und einen hohen Stromverbrauch haben. Durch den Preis und die Stromaufnahme sind somit der Erhöhung der Abtastrate aus wirtschaftlichen und technischen Gründen Grenzen gesetzt.

Die Genauigkeitsverbesserung durch softwaremäßige Auswertung beruht darauf, daß eine sinusförmige Größe, hier die Grundwelle, schon durch ein Wertepaar, nämlich Betrag und Winkel, eindeutig bestimmt ist. Damit würde bei Strömen ohne Oberwellen ein Abtastwert pro Periode völlig ausreichen, um den Strom hinreichend genau zu bestimmen.

Diese idealisierten Bedingungen liegen jedoch in der Praxis nicht vor. Praktische Realität ist vielmehr das Auftreten von Oberwellen in den Betriebsströmen sowie die Schwierigkeit, die Phasenlage bei oberwellenbehafteten Strömen genau festzustellen. Aus diesen Gründen wurde auf eine derartige Stromerfassung sowie Auswertung bisher verzichtet.

In der Praxis wurde bisher zur Berechnung des Effektivwertes eine möglichst hohe Anzahl von Abtastungen ohne Berücksichtigung der Phasenlage pro Periode erfaßt. Die Abtastwerte wurden quadriert, über eine festgelegte Zeit aufsummiert und daraus der Mittelwert gebildet. Eine elektronische Auslöseeinheit für einen Leistungsschalter, bei welcher ein Mikrocomputer zur Ermittlung des Effektivwertes des Leitungsstromes eingesetzt wird, ist in der DE 43 23 356 C1 beschrieben.

Der Erfindung liegt die Aufgabe zu Grunde, ein Verfahren und eine Schaltungsanordnung zur Stromerfassung zu schaffen, welche mit einfachen Mitteln eine genaue Stromerfassung ermöglichen und eine präzise, zuverlässige und reproduzierbare Auslösung von Leistungsschaltern gewährleisten.

Diese Aufgabe wird erfindungsgemäß gelöst durch die Merkmale im kennzeichnenden Teil der Ansprüche 1 und 3. Zweckmäßige Ausgestaltungen der Erfindung sind in den Unteransprüchen enthalten.

Ein besonderer Vorteil der Erfindung besteht darin, daß die Auslösegenauigkeit von elektronischen Auslösern in Leistungsschaltern durch einfache Maßnahmen mit geringem Aufwand wesentlich verbessert werden kann, indem die Stromerfassung nach Betrag und Phase erfolgt, derart, daß nur die Grundwelle des Stromes zwischen exakt bestimmten Stromnulldurchgängen mit geringer Abtastrate abgetastet und aus der ermittelten Phasenlage sowie dem Betrag der Effektivwert berechnet wird. Dies wird dadurch realisiert, daß parallel zum Eingang des A/D-Wandlers sowie einem Porteingang des Mikroprozessors eine PLL-Schaltung mit nachgeschaltetem Nullpunktschalter angeordnet ist.

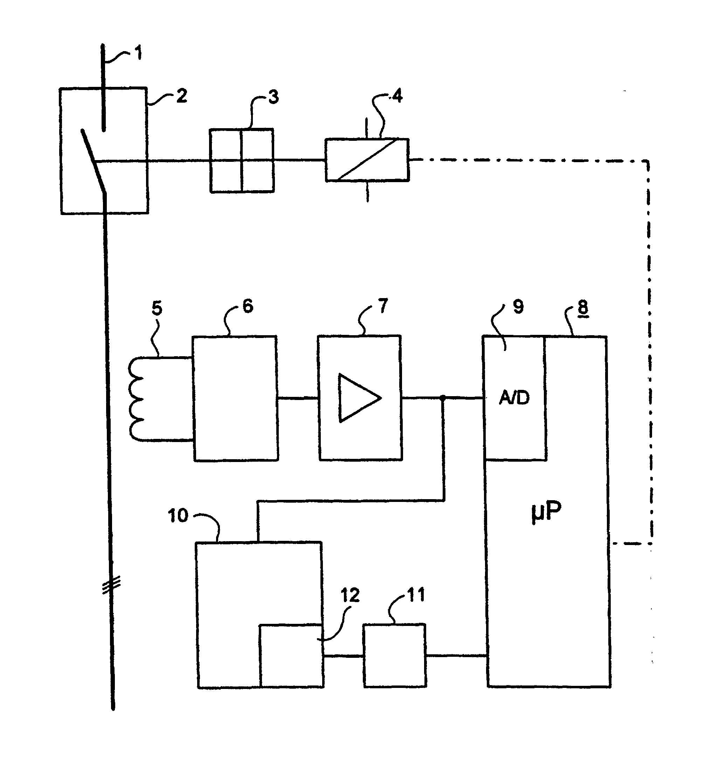

Die Erfindung soll nachstehend anhand von einem zumindest teilweise in der Figur dargestelltem Ausführungsbeispiel näher erläutert werden.

In der Figur ist bei vereinfachter einpoliger Darstellung mit 1 die Hauptstrombahn eines Niederspannungs-Leistungsschalters bezeichnet. Ein zu der Hauptstrombahn 1 gehörender Schaltkontakt 2 ist in bekannter Weise durch ein Schaltschloß 3 in der geschlossenen Schaltstellung verklinkbar und kann durch einen Auslösemagnet 4 zum Ausschalten freigegeben werden. Zur Stromerfassung dient eine der Hauptstrombahn 1 zugeordnete Rogowskispule 5 in Verbindung mit einem Integrator 6 und einem Normierverstärker 7. Die aus dieser Schaltungsanordnung gewonnenen Stromsignale werden in einem Mikroprozessor 8 verarbeitet, nachdem sie durch einen A/D-Wandler in eine hierzu geeignete Form umgewandelt wurden.

Die Stromerfassung nach Betrag und Phasenlage wird dadurch möglich, daß unter Verwendung einer herkömmlichen, beispielsweise aus der Nachrichtentechnik bekannten PLL-(Phase-lockedloop) Schaltung 10 mit nachgeschaltetem Nullpunktschalter 11 eine genaue Phasenlage ermittelt werden kann. Die genaue Messung der Phasenlage, auch bei Strömen mit einem großen Anteil von Oberwellen, wird dadurch erreicht, daß parallel zum Eingang des A/D-Wandlers 9 sowie einem Porteingang des Mikroprozessors 8 die PLL-Schaltung 10 angekoppelt ist. Der in der PLL-Schaltung 10 enthaltene gesteuerte Oszillator 12 ist frequenzmäßig so begrenzt, daß er nur auf die Grundwelle des Stromes einrasten kann. Dem gesteuerten Oszillator 12 ist der Nullpunktschalter 11 nachgeordnet, der exakt im Stromnulldurchgang einen Flankenwechsel abgibt, welcher über einen Porteingang vom Mikroprozessor 8 erkannt wird. Mit Hilfe des Prozessortaktes als Zeitmaßstab sowie der festen Phasenbeziehung zwischen gesteuertem Oszillator 12 und Primärstrom kann von der Software ein genaues Wertepaar, bestehend aus Betrag und Phase, gebildet werden. Es wird eine von der Software gesteuerte Abtastung des analogen Stromsignals vorgenommen, mit der eine sehr genaue Effektivwertberechnung bei geringer Abtastrate möglich ist.

Die Erfindung ist nicht beschränkt auf das hier dargestellte Ausführungsbeispiel. Vielmehr ist es möglich, durch Kombination und Modifikation der genannten Mittel und Merkmale weitere Ausführungsformen zu realisieren, ohne den Rahmen der Erfindung zu verlassen.

## Patentansprüche

1. Verfahren zur Stromerfassung zum Erzeugen eines Auslösesignals, wobei ein analoges Stromsignal abgetastet und in digitale Werte umgeformt wird und eine Effektivwertberechnung erfolgt,
**dadurch gekennzeichnet, daß**
die Stromerfassung nach Betrag und Phase erfolgt, derart, daß nur die Grundwelle des Stromes zwischen exakt bestimmten Stromnulldurchgängen mit geringer Abtastrate abgetastet und aus der ermittelten Phasenlage sowie dem Betrag der Effektivwert berechnet wird.

2. Verfahren nach Anspruch 1,
**dadurch gekennzeichnet, daß**
die Abtastung von einer Software gesteuert wird.

3. Schaltungsanordnung zur Stromerfassung zum Erzeugen eines Auslösesignales für einen Leistungsschalter mit elektronischem Auslöser mit in einer Hauptstrombahn (1) angeordnetem Schaltkontakt (2), Schaltschloß (3), Auslösemagnet (4), Rogowskispule (5), Integrator (6), Normierverstärker (7) und Mikroprozessor (8) mit A/D-Wandler (9),
**dadurch gekennzeichnet, daß**
parallel zum Eingang des A/D-Wandlers (9) sowie einem Porteingang des Mikroprozessors (8) eine PLL-Schaltung (10) mit nachgeschaltetem Nullpunktschalter (11) angeordnet ist.

4. Schaltungsanordnung nach Anspruch 3,
**dadurch gekennzeichnet, daß**
ein in der PLL-Schaltung (10) enthaltener, gesteuerter Oszillator (12) frequenzmäßig begrenzt ist derart, daß er nur auf die Grundwelle des Stromes einrasten kann.

5. Schaltungsanordnung nach Anspruch 3,
**dadurch gekennzeichnet, daß**
der Nullpunktschalter (11) exakt im Stromnulldurchgang der Grundwelle ein Signal für einen Flankenwechsel abgibt.

## Revendications

1. Procédé de détection de courant pour produire un signal de déclenchement, un signal de courant analogique étant échantillonné et transformé en valeurs numériques et un calcul de valeur efficace étant effectué,
**caractérisé par le fait qu'**on effectue la détection de courant en amplitude et en phase en échantillonnant avec un petit taux d'échantillonnage seulement l'onde fondamentale du courant entre des passages du courant par zéro exactement déterminés et on calcule la valeur efficace à partir de la relation de phase déterminée ainsi que de l'amplitude.

2. Procédé selon la revendication 1,
**caractérisé par le fait qu'**on commande l'échantillonnage au moyen d'un logiciel.

3. Circuit de détection de courant pour produire un signal de déclenchement pour un disjoncteur à déclencheur électronique, comportant dans un trajet de courant principal (1) un contact de commutation (2), un verrou de maintien (3), un électro-aimant de déclenchement (4), une bobine de Rogovski (5), un intégrateur (6), un amplificateur normatif (7) et un microprocesseur (8) avec convertisseur analogique-numérique (9),
**caractérisé par le fait qu'**une boucle à verrouillage de phase PLL (10) avec commutateur au point zéro (11) branché du côté aval est montée en parallèle avec l'entrée du convertisseur analogique-numérique (9) ainsi qu'avec une entrée de port du microprocesseur (8).

4. Circuit selon la revendication 3,
**caractérisé par le fait qu'**un oscillateur commandé (12) contenu dans la boucle à verrouillage de phase PLL (10) est limité en fréquence de telle sorte qu'il ne peut enclencher que sur l'onde fondamentale du courant.

5. Circuit selon la revendication 3,
**caractérisé par le fait que** le commutateur au point zéro (11) délivre un signal pour le changement de front exactement au passage par zéro du courant de l'onde fondamentale.

## Claims

1. Method for current detection for generating a release signal, an analogue current signal being sampled and converted into digital values and a root-mean-square value calculation being effected,
**characterized in that**
the current detection is effected according to magnitude and phase, in such a way that only the fundamental wave of the current between exactly specified current zero crossings is sampled at a low sampling rate and the root-mean-square value is calculated from the phase angle determined and the magnitude.

2. Method according to Claim 1,
**characterized in that**
the sampling is controlled by a software.

3. Circuit arrangement for current detection for generating a release signal for a circuit-breaker with electronic release with a switching contact (2) arranged in a main current path (1), latch (3), release magnet (4), Rogovski coil (5), integrator (6), normalizing amplifier (7) and microprocessor (8) with A/D converter (9),
**characterized in that**
a PLL circuit (10) with zero switch (11) connected downstream is arranged in parallel with the input of the A/D converter (9) and a port input of the microprocessor (8).

4. Circuit arrangement according to Claim 3,
**characterized in that**
a controlled oscillator (12) contained in the PLL circuit (10) is limited in terms of frequency in such a way that it can only lock onto the fundamental wave of the current.

5. Circuit arrangement according to Claim 3,
**characterized in that**
the zero switch (11) outputs a signal for an edge change exactly at the current zero crossing of the fundamental wave.
